# EUROPÄISCHE PATENTSCHRIFT

(11) **EP 2 972 431 B1**
(45) Veröffentlichungstag und Bekanntmachung des Hinweises auf die Patenterteilung: **10.05.2017**
(21) Anmeldenummer: 14710533.2
(22) Anmeldetag: 13.03.2014
(51) Int. Cl.: H02K 5/16, H02K 5/167, H02K 5/24, H02K 11/20, H02K 11/33, G01R 31/34

(54) **ELEKTROMOTOR MIT FUNKTIONSÜBERWACHUNG DER MOTORLAGER**
ELECTRIC MOTOR WITH FUNCTIONAL MONITORING OF THE MOTOR BEARINGS
MOTEUR ÉLECTRIQUE AVEC SURVEILLANCE FONCTIONNELLE DES PALIERS DE MOTEUR

(30) Priorität: 14.03.2013 DE 102013102648
(43) Veröffentlichungstag der Anmeldung: 20.01.2016
(73) Patentinhaber: EBM-Papst Mulfingen GmbH&CO. KG, 74673 Mulfingen (DE)
(72) Erfinder: SAUER, Thomas, 97980 Bad Mergentheim (DE)
(74) Vertreter: Jostarndt Patentanwalts-AG
(86) Internationale Anmeldenummer: PCT/EP2014/054929
(87) Internationale Veröffentlichungsnummer: WO 2014/140155

(56) Entgegenhaltungen:
- DE-A1- 10 313 273
- US-A1- 2012 181 965
- LEE HONG-JOO ET AL: "Acoustic resonance of outer-rotor brushless dc motor for air-conditioner fan", JOURNAL OF APPLIED PHYSICS, AMERICAN INSTITUTE OF PHYSICS, US, Bd. 103, Nr. 7, 28. Februar 2008 (2008-02-28), Seiten 7F116-7F116, XP012110371, ISSN: 0021-8979, DOI: 10.1063/1.2838327

## Beschreibung

Die vorliegende Erfindung betrifft einen Elektromotor, umfassend einen Stator und einen relativ zu diesem drehbar in Lagern gelagerten Rotor sowie ein Motorgehäuse sowie einen Schwingungssensor zur Aufnahme von im Elektromotor auftretenden Schwingungen, die durch Funktionsstörungen an den Lagern verursacht werden.

In der Industrie sind Systeme weit verbreitet, bei denen ein oder mehrere Vibrations- oder Schwingschnellesensoren außen auf dem Gehäuse des zu überwachenden Motors angebracht sind. Hierzu kann z. B. auf die US 5,629,870 verwiesen werden. Hierbei wird das Signal des Sensors von einer separaten Elektronik ausgewertet und dem Betreiber ein Signal zur Verfügung gestellt, das den gemessenen Schwingungen den unterschiedlichen Fehlerursachen zuordnen kann. Hierdurch ergibt sich ein erheblicher Schaltungsaufwand und eine unerwünschte Fehleranfälligkeit. Eine entsprechende Anordnung ist auch aus der US 5,726,911 bekannt. Eine weitere Anordnung ist aus der DE 103 13 273 A1 bekannt. Der vorliegenden Erfindung liegt die Aufgabe zu Grunde, ausgehend von einem gattungsgemäßen Elektromotor, diesen derart zu verbessern, dass mit geringem Bauteil- und Schaltungsaufwand kostengünstig eine sichere Funktionsüberwachung der Lager des Motors erfolgen kann.

Erfindungsgemäß wird dies dadurch erreicht, dass bei einer Ausbildung des Elektromotors als Außenläufermotor, bei dem der Stator ein Lagertragrohr aufweist, das einendig mit einem ringförmigen Statorflansch verbunden ist, und in dem Lagertragrohr in Richtung einer mittleren Längsachse des Lagertragrohrs zueinander beabstandete Lageranordnungen angeordnet sind, in dem eine Welle des Rotors gelagert ist, und der Schwingungssensor am Statorflansch auf dessen vom Rotor abgewandten Seite befestigt ist. Der Schwingungssensor ist vorteilhafterweise als Schwingschnellesensor ausgebildet, wobei es sich beispielsweise um einen Laser-Doppler-Vibrometer, ein MEMS (Micro-Electro-Mechanical System) auf Halbleiterbasis oder einen Piezosensor handeln kann. Der Schwingungssensor ist direkt auf einer Freifläche des Statorflansches befestigt, die in radialer Richtung zur Längsachse sich unmittelbar an das Lagertragrohr anschließt. Hierbei ist der Statorflansch mit dem Lagertragrohr einstückig ausgebildet. Erfindungsgemäß können demnach die beiden im Lagertragrohr angeordneten Lager mit demselben Schwingungssensor gleichzeitig überwacht werden. Hierbei kann zwar nicht sicher differenziert werden, welches der beiden Lager von einem Schaden betroffen ist, dies führt jedoch nicht zu einer Beeinträchtigung der Systemfunktion, da sowieso der gesamte Elektromotor ausgetauscht wird, da die typischerweise als Festsitzlager mit Presssitz in dem Lagertragrohr befindlichen Lager vor Ort nicht ausgetauscht werden können. Ein erfindungsgemäßer Motor kann insbesondere zum Antrieb von Ventilatoren benutzt werden, wobei es sich um ein Massenprodukt handelt, bei dem es insbesondere auf eine kostengünstige und fehlerunanfällige Lösung ankommt. Bei dem erfindungsgemäßen Elektromotor handelt es sich vorzugsweise um einen bürstenlosen Außenläufermotor mit integrierter Elektronik, wobei die Elektronik vorteilhafterweise in einem Teilgehäuse angeordnet ist, das am Statorflansch auf dessen vom Rotor abgekehrten Seite befestigt ist. In diesem Gehäuse ist auch der erfindungsgemäße Schwingungssensor angeordnet.

Da erfindungsgemäß der Sensor derart angeordnet ist, dass nur ein kurzer Entfernungsweg zu den Lagern vorhanden ist, ist die Übertragung hochfrequenter Körperschallanteile ohne Weiteres möglich.

Vorteilhafte Ausführungen der Erfindung sind in den Unteransprüchen enthalten und werden an Hand des in der beiliegenden Zeichnung dargestellten Ausführungsbeispiels näher erläutert. Es zeigt:

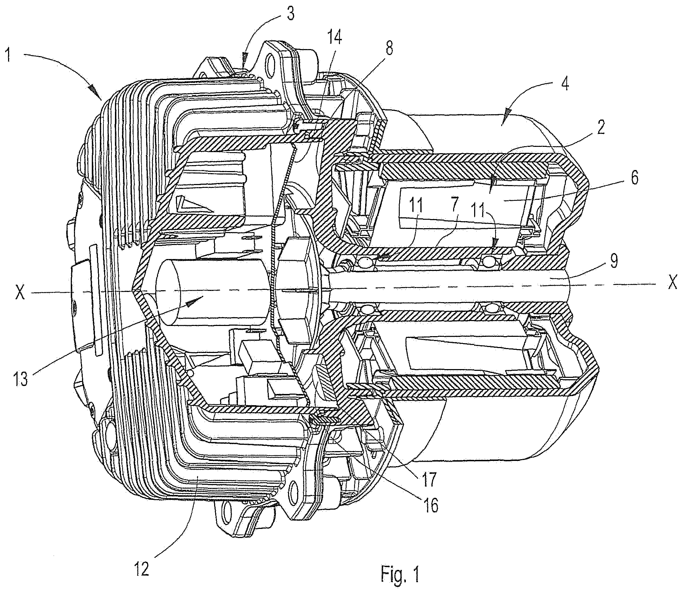

- Fig. 1: eine perspektivische Ansicht eines erfindungsgemäßen Elektromotors, zum Teil geschnitten.

Sofern bestimmte beschriebene und/oder aus der Zeichnung entnehmbare Merkmale des erfindungsgemäßen Elektromotors nur im Zusammenhang mit einem oder mehreren Merkmalen beschrieben sind, sind diese aber auch gemäß der Erfindung unabhängig von diesem Ausführungsbeispiel als Einzelmerkmal oder aber auch in Kombination mit anderen Merkmalen des Ausführungsbeispiels wesentlich und werden als zur Erfindung gehörig beansprucht.

Der in Fig. 1 dargestellte Elektromotor 1 ist vorzugsweise als kollektorloser elektronisch kommutierter Gleichstrom-Außenläufermotor ausgebildet. Der Elektromotor 1 besteht aus einem Stator 2 und einem, den Stator 2 von einer Seite her als Teil eines Motorgehäuses 3 topfartig umschließenden, als Außenläufer ausgebildeten Rotor 4. Der Stator 2 besteht aus einem Statorblechpaket 6 mit einzelnen nicht näher dargestellten Statorwicklungen, die insbesondere als Einzelzahnwicklung ausgeführt sind. Der Stator 2 weist ein Lagertragrohr 7 auf, das innerhalb des Statorblechpaketes 6 verläuft und eine mittlere Längsachse X-X aufweist. An dem Lagertragrohr 7 ist einseitig ein Statorflansch 8 befestigt, der vorzugsweise einteilig mit dem Lagertragrohr 7 ausgebildet ist. Der Statorflansch 8 ist ringförmig geformt. Der Rotor 4 ist über eine Welle 9 und über Lageranordnungen 11 im Lagertragrohr 7 drehbar gelagert. Die Lageranordnungen 11 sind mit Presssitz innerhalb des Lagertragrohrs 7 angeordnet und sind in axialer Richtung voneinander beabstandet. Auf der dem Rotor 4 abgewandten Seite des Statorflansches 8 schließt sich als weiterer Teil des Motorgehäuses 3 ein Teilgehäuse 12 an, das zur Aufnahme einer Motorelektronik 13 dient, von der einzelne Elektronikbauelemente auf einer Leiterplatte 14 angeordnet sind.

Erfindungsgemäß weist der Statorflansch 8 auf seiner vom Rotor 4 abgekehrten Seite innerhalb des Teilgehäuses 12 einen Schwingungssensor 16 auf. Dieser Schwingungssensor 16 ist vorzugsweise als Schwingschnellesensor ausgebildet, wobei es sich beispielsweise um einen Laser-Doppler-Vibrometer, ein MEMS (Micro-Electro-Mechanical System) auf Halbleiterbasis oder einen Piezosensor handeln kann. Der Schwingungssensor 16 ist vorzugsweise direkt auf einer Freifläche 17 des Statorflansches 8 befestigt, die in radialer Richtung zur Längsachse X-X sich unmittelbar an das Lagertragrohr 7 anschließt. Es kann sich hier um eine Freifläche 17 handeln, die wie in Fig. 1 dargestellt, der Leiterplatte 14 gegenüberliegend angeordnet ist, oder um eine Freifläche 17 auf der dem Stator 6 gegenüberliegenden Seite. Hierdurch ergibt sich nur ein kurzer Abstand zu den Lageranordnungen 11, wodurch die Übertragung hochfrequenter Körperschallanteile möglich ist. Insbesondere durch die einteilige erfindungsgemäße Ausführung des Statorflansches 8 und des Lagertragrohrs 7 ist eine Aufnahme der Schwingschnelle der beiden Lageranordnungen 11 mit ein und demselben Sensor möglich. Der Schwingungssensor 16 wird über ein nicht dargestelltes Signalkabel mit einer Auswertelektronik, die ebenfalls nicht dargestellt ist, die auf der Leiterplatte 14 angeordnet ist, verbunden. Durch die unmittelbare Nähe des erfindungsgemäßen Schwingungssensors 16 zur Leiterplatte 14 und der auf dieser angeordneten Motorelektronik 13, ergibt sich eine kompakte und kostengünstige Bauweise. Hierbei ist es möglich, um zusätzliche Systemkosten zu reduzieren, die Rechenfunktion, die zur Ausführung einer auf der Leiterplatte 14 angeordneten Kommutierungselektronik erforderlich ist, zu nutzen, indem die Berechnung der Lagerausfalldaten als sehr langsame Rechenfunktion im Hauptprogramm des bereits für die Kommutierungselektronik vorhandenen Prozessors durchgeführt wird. Erfindungsgemäß kann aber auch ein eigener Prozessor für die Auswertung der vom Schwingungssensor 16 erzeugten Signale vorgesehen sein, wobei dieser Prozessor ebenfalls auf der Leiterplatte 14 angeordnet würde und beispielsweise den Niederspannungsteil der Motorelektronik 13 nutzen könnte, wie auch vorhandene EMV-Filter und viele weitere Komponenten. Weiterhin kann es erfindungsgemäß zweckmäßig sein, wenn zwischen dem Schwingungssensor 16 und dem Statorflansch 8 ein metallisches Körperschallleitelement, z. B. in Form einer vorzugsweise runden Scheibe, angeordnet ist. Ein derartiges Körperschallleitelement kann dazu dienen, um den genauen Abstand zwischen dem Statorflansch 8 und der Leiterplatte 14 einzustellen oder um zusätzlich die Einleitung des elektrischen Signalkabels zum Sensor an einer optimalen Stelle zu ermöglichen. Über die Rückseite oder Seitenfläche des Schwingungssensors 16 kann das Signalkabel an den Schwingungssensor 16 geführt werden.

Falls in einer Anlage mehrere erfindungsgemäße Elektromotoren 1 angeordnet sind, die innerhalb der Anlage mechanisch gekoppelt sind, kann es zweckmäßig sein, um eine gegenseitige Beeinflussung der von den jeweiligen Schwingungssensoren 16 gemessenen Sensorwerte zu vermeiden, dass die einzelnen Elektromotoren 1 gegeneinander schwingungsgemäß entkoppelt sind. Dies kann beispielsweise im Bereich des Statorflansches 8 erfolgen oder aber beispielsweise bei Axialventilatoren, die einen erfindungsgemäßen Elektromotor 1 aufweisen, an einer äußeren Schutzgitteraufnahme des jeweiligen Lüfters.

Erfindungsgemäß wird ein Elektromotor 1 geschaffen, bei dem der Schwingungssensor 16 vollständig innerhalb des Motors integriert ist. Da nur ein Sensor zur Messung erforderlich ist, entstehen minimale Kosten, und durch die Anordnung in unmittelbarer Nähe zur Motorelektronik ergibt sich die Möglichkeit einer Mehrfachnutzung der bereits vorhandenen Elektronikbauteile.

### Bezugszeichenliste

- 1: Elektromotor
- 2: Stator
- 3: Motorgehäuse
- 4: Rotor
- 6: Statorblechpaket
- 7: Lagertragrohr
- 8: Statorflansch
- 9: Welle
- 11: Lageranordnungen
- 12: Teilgehäuse
- 13: Motorelektronik
- 14: Leiterplatte
- 16: Schwingungssensor
- 17: Freifläche
- X-X: Längsachse

## Patentansprüche

1. Elektromotor (1), umfassend einen Stator (2) mit einem relativ zu diesem drehbar in Lageranordnungen (11) gelagerten Rotor (4) sowie ein Motorgehäuse (3, 12) und einen Schwingungssensor (16) zur Aufnahme von im Elektromotor (1) auftretenden Schwingungen, die durch Funktionsstörungen an den Lageranordnungen (11) verursacht werden, wobei der Elektromotor als Außenläufermotor ausgebildet ist, wobei der Stator (2) ein Lagertragrohr (7) aufweist, das einendig mit einem ringförmigen Statorflansch (8) verbunden ist, und in dem Lagertragrohr (7) in Richtung einer mittleren Längsachse (X-X) des Lagertragrohrs (7) zueinander beabstandete Lageranordnungen (11) angeordnet sind, in denen eine Welle (9) des Rotors (4) gelagert ist, **dadurch gekennzeichnet, dass** der Schwingungssensor (16) entweder direkt oder mittels eines zwischen dem Schwingungssensor (16) und dem Statorflansch (8) angeordneten metallischen Körperschall-Leitelements, z.B. in Form einer Scheibe, auf einer Freifläche (17) des Statorflansches (8) befestigt ist, die in radialer Richtung zur Längsachse (X-X) sich unmittelbar an das Lagertragrohr (7) anschließt und wobei der Statorflansch (8) und das Lagertragrohr (7) einstückig ausgebildet sind.

2. Elektromotor (1) nach Anspruch 1,
**dadurch gekennzeichnet,**
**dass** der Schwingungssensor (16) auf der vom Rotor (2) abgewandten oder auf der dem Rotor (2) zugewandten Seite des Statorflansches (8) befestigt ist.

3. Elektromotor (1) nach Anspruch 1 oder 2,
**dadurch gekennzeichnet,**
**dass** der Schwingungssensor (16) als Schwingschnellesensor ausgebildet ist.

4. Elektromotor (1) nach Anspruch 3,
**dadurch gekennzeichnet, dass** der Schwingschnellesensor (16) ein LaserDoppler-Vibrometer, ein MEMS auf Halbleiterbasis oder ein Piezosensor ist.

5. Elektromotor (1) nach einem der Ansprüche 1 bis 4, **dadurch gekennzeichnet,**
**dass** das Lagertragrohr (7) innerhalb eines Statorblechpaketes (6) angeordnet ist, das als Einzelzahnwicklungen ausgebildete Motorwicklungen aufweist.

6. Elektromotor (1) nach einem der Ansprüche 1 bis 5,
**dadurch gekennzeichnet,**
**dass** an dem Statorflansch (8) auf seiner vom Rotor (4) abgewandten Seite ein eine Motorelektronik (13) aufweisendes Teilgehäuse (12) befestigt ist, in dem der Schwingungssensor (16) aufgenommen ist.

7. Elektromotor (1) nach Anspruch 6, **dadurch gekennzeichnet,**
**dass** der Schwingungssensor (16) über ein Signalkabel mit einer auf einer Leiterplatte (14) der Motorelektronik (13) angeordneten Auswertelektronik verbunden ist.

## Claims

1. An electric motor (1), comprising a stator (2) and a rotor (4) that can rotate relative to the stator (2) and that is mounted in bearing arrangements (11), and also comprising a motor housing (3, 12) and a vibration sensor (16) to pick up vibrations that occur in the electric motor (1) and that are caused by malfunctions of the bearing arrangements (11), whereby the electric motor is configured as an external-rotor motor, whereby the stator (2) has a bearing support tube (7) that is connected at one end to a ring-shaped stator flange (8), and bearing arrangements (11) are arranged at a distance from each other in the bearing support tube (7) in the direction of a center longitudinal axis (X-X) of the bearing support tube (7), in which a shaft (9) of the rotor (4) is supported,
**characterized in that**
the vibration sensor (16) is attached - either directly or via a metal structure-borne sound-conducting element, for example, in the form of a disc, that is arranged between the vibration sensor (16) and the stator flange (8) - to a free surface (17) of the stator flange (8) that immediately adjoins the bearing support tube (7) in the radial direction relative to the longitudinal axis (X-X), and whereby the stator flange (8) and the bearing support tube (7) are configured in one piece.

2. The electric motor (1) according to claim 1,
**characterized in that**
the vibration sensor (16) is attached on the side of the stator flange (8) facing away from the rotor (2) or on the side of the stator flange (8) facing the rotor (2).

3. The electric motor (1) according to claim 1 or 2,
**characterized in that**
the vibration sensor (16) is configured as a vibration rate sensor.

4. The electric motor (1) according to claim 3,
**characterized in that**
the vibration rate sensor (16) is a laser-Doppler vibrometer, a MEMS based on a semiconductor, or else a piezoelectric sensor.

5. The electric motor (1) according to one of claims 1 to 4,
**characterized in that**
the bearing support tube (7) is arranged inside the stator laminated core (6), which has motor windings configured as single-tooth windings.

6. The electric motor (1) according to one of claims 1 to 5,
**characterized in that,** on the stator flange (8), on the side facing away from the rotor (4), a partial housing (12) is attached which holds the motor electronics (13) and in which the vibration sensor (16) is accommodated.

7. The electric motor (1) according to claim 6,
**characterized in that**
the vibration sensor (16) is connected via a signal cable to evaluation electronics that are arranged on a printed circuit board (14) of the motor electronics (13).

## Revendications

1. Moteur électrique (1) comprenant un stator (2) avec un rotor (4) logé mobile dans des systèmes de paliers (11) relativement à celui-ci, et un carter moteur (3, 12) et un capteur d'oscillations (16) destiné à absorber des oscillations qui surviennent dans le moteur électrique (1) et sont causées par des dysfonctionnements au niveau des systèmes de paliers (11), le moteur électrique étant réalisé en tant que moteur à rotor externe, le stator (2) comportant un tube porteur de palier (7) qui est relié en une extrémité à un flasque de stator annulaire (8), et dans le tube porteur de palier (7) étant agencés, en direction d'un axe longitudinal central (X-X) du tube porteur de palier (7), des systèmes de paliers (11) espacés entre eux et dans lesquels est logé un arbre (9) du rotor (4), **caractérisé en ce que** le capteur d'oscillations (16) est fixé directement ou au moyen d'un élément métallique conducteur de bruit de structure situé entre le capteur d'oscillations (16) et le flasque de stator (8), par exemple en forme de disque, sur une surface libre (17) du flasque de stator (8) qui fait directement suite au tube porteur de palier (7) dans la direction radiale par rapport à l'axe longitudinal (X-X) et le flasque de stator (8) et le tube porteur de palier (7) étant réalisés d'une seule pièce.

2. Moteur électrique (1) selon la revendication 1, **caractérisé en ce que** le capteur d'oscillations (16) est fixé sur le côté du flasque de stator (8) opposé au rotor (2) ou en regard du rotor (2).

3. Moteur électrique (1) selon la revendication 1 ou 2, **caractérisé en ce que** le capteur d'oscillations (16) est réalisé en tant que capteur de vitesse d'oscillation.

4. Moteur électrique (1) selon la revendication 3, **caractérisé en ce que** le capteur de vitesse d'oscillation (16) est un vibromètre Doppler à laser, un MEMS à base de semi-conducteur ou un piézo-capteur.

5. Moteur électrique (1) selon l'une des revendications 1 à 4, **caractérisé en ce que** le tube porteur de palier (7) est situé dans un ensemble de tôles de stator (6) qui comporte des enroulements de moteur réalisés en tant qu'enroulements à dent unique.

6. Moteur électrique (1) selon l'une des revendications 1 à 5, **caractérisé en ce qu'**est fixé, sur le flasque de stator (8), sur son côté opposé au rotor (4), un boîtier partiel (12) comportant une électronique de moteur et dans lequel est logé le capteur d'oscillations (16).

7. Moteur électrique selon la revendication 6, **caractérisé en ce que** le capteur d'oscillation (16) est relié via un câble de signaux à une électronique d'évaluation située sur une carte de circuit imprimé (14) de l'électronique de moteur (13).
